# FASCICULE DE BREVET EUROPEEN

(11) **EP 3 964 298 B1**
(45) Date de publication et mention de la délivrance du brevet: **26.06.2024**
(21) Numéro de dépôt: 21195100.9
(22) Date de dépôt: 06.09.2021
(51) Int. Cl.: B05C 5/02, B05B 1/30

(54) **DISPOSITIF D'APPLICATION D'UN PRODUIT, MACHINE COMPRENANT UN TEL DISPOSITIF ET PROCÉDÉ DE CONTRÔLE D'UNE TELLE MACHINE**
VORRICHTUNG ZUM AUFBRINGEN EINES PRODUKTS, MASCHINE, DIE EINE SOLCHE VORRICHTUNG UMFASST, UND STEUERUNGSVERFAHREN EINER SOLCHEN MASCHINE
DEVICE FOR APPLYING A PRODUCT, MACHINE COMPRISING SUCH A DEVICE AND METHOD FOR CONTROLLING SUCH A MACHINE

(30) Priorité: 07.09.2020 FR 2009063
(43) Date de publication de la demande: 09.03.2022
(73) Titulaire: Exel Industries, 51200 Epernay (FR)
(72) Inventeur: BATLLO, Benoit, 51200 EPERNAY (FR); ROBERT, Stéphane, 51200 EPERNAY (FR)
(74) Mandataire: Lavoix

(56) Documents cités:
- DE-A1- 10 216 631

## Description

La présente invention concerne un dispositif d'application d'un produit, une machine d'application de produit comprenant un tel dispositif et un procédé de contrôle d'une telle machine.

Dans le domaine de l'application de produits de collage ou d'étanchéité par des systèmes robotisés, il peut être nécessaire de modifier rapidement le débit d'application pour par exemple, obtenir un cordon de colle ou de mastic plus large ou plus étroit. Cette modification de largeur doit être rapide pour garantir des résultats propres et éviter des pertes de produits coûteux. Ces produits étant visqueux, des systèmes doivent être conçus spécifiquement.

Les systèmes de dosage électrique du produit ou de régulation de pression sont actionnés par des moteurs. Dans le cas d'applications peu dynamiques et proches du système de dosage, la vitesse du moteur est proportionnelle au débit de sortie du produit. Dans le cas d'applications plus dynamiques ou lorsque l'application est éloignée du système de dosage, les systèmes de dosage ou de régulation de pression ont des temps de réaction relativement importants du fait de la compressibilité des produits, de l'élasticité des flexibles et des hautes pressions en jeu.

Pour obtenir des changements de débit rapide, il est connu d'utiliser des systèmes mécaniques créant des restrictions réglables avant les buses d'application de produit, avec des pièces mobiles. De telles solutions présentent plusieurs désavantages :
- Il n'est pas possible d'arrêter rapidement la dépose de produit du fait du volume à décompresser entre la restriction et la buse. La fin de cordon d'application n'est donc pas nette.
- Les produits sont abrasifs et causent de l'usure sur les pièces mobiles et des fuites.
- Les actionneurs nécessaires pour le déplacement des pièces mobiles doivent être rapides et puissants et sont donc coûteux.
- Des joints spécifiques doivent être conçus pour toutes les pièces mobiles, ce qui engendre un surcoût.
- Le pointeau et le siège de la vanne doivent être spécifiquement conçus, ce qui ne permet pas d'utiliser un dispositif d'application à débit non variable préexistant.

Le document DE 102 16 631 A1 décrit un dispositif pour le huilage de surfaces de planches, comprenant une tête de buse. La tête de buse s'appuie sur son côté opposé à l'extrémité de buse contre un excentrique qui peut être mis en rotation par un moteur pour déplacer l'aiguille de buse contre la force d'un accumulateur d'énergie pour passer en position ouverte, en position fermée ou dans une position intermédiaire entre les deux.

L'objectif de l'invention est de proposer un nouveau dispositif d'application de produit, permettant d'obtenir des variations rapides de débit d'application de produit, avec des pièces mécaniques dont le coût et la complexité sont faibles par rapport aux solutions existantes, de meilleures performances et une meilleure fiabilité.

A cet effet, l'invention concerne un dispositif d'application de produit, selon la revendication 1.

Grâce à l'invention, le positionnement du pointeau à des positions intermédiaires permet de créer une restriction réglable ne nécessitant pas d'actionneurs coûteux ou de conceptions spécifiques de solutions d'étanchéité.

Selon des aspects avantageux mais non obligatoires de l'invention, un tel dispositif d'application de produit peut incorporer une ou plusieurs des caractéristiques des revendications 2 à 7, prises dans toutes combinaisons techniquement admissibles.

L'invention concerne également une machine d'application de produit selon la revendication 8.

L'invention concerne également un procédé de contrôle d'une machine d'application de produit selon la revendication 9.

Selon des aspects avantageux mais non obligatoires de l'invention, un tel procédé de contrôle peut incorporer une ou plusieurs des caractéristiques des revendications 10 et 11, prises dans toutes combinaisons techniquement admissibles.

L'invention sera mieux comprise et d'autres avantages de celle-ci apparaitront plus clairement à la lumière de la description qui va suivre d'un dispositif d'application de produit, d'une machine d'application de produit et d'un procédé de contrôle conformes à son principe, faite à titre d'exemple non limitatif en référence aux dessins annexés dans lesquels :
[Fig 1] La Figure 1 est une coupe schématique d'une machine d'application de produit divulgué mais non revendiqué, comprenant un dispositif d'application de produit conforme à un premier mode de réalisation divulgué mais non revendiqué, le dispositif d'application de produit étant dans une configuration ouverte;
[Fig 2] La figure 2 est une coupe schématique du dispositif d'application de produit de la figure 1 dans une configuration intermédiaire ;
[Fig 3] La figure 3 est une coupe vue schématique du dispositif d'application de produit de la figure 3 dans une configuration fermée
[Fig 4] La figure 4 est une vue en perspective partiellement sectionnée du dispositif d'application de la figure 1, montrant une butée dans une configuration basse en configuration fermée du dispositif;
[Fig 5] La figure 5 est une vue en perspective partiellement sectionnée du dispositif d'application de la figure 1 montrant la butée dans une configuration intermédiaire;
[Fig 6] La figure 6 est une vue en perspective partiellement sectionnée du dispositif d'application de la figure 1, montrant la butée dans une configuration d'ouverture maximale;
[Fig 7] La Figure 7 est un graphique de fonctionnement d'une méthode de contrôle d'une machine d'application conforme à l'invention ;
[Fig 8] La Figure 8 est une coupe schématique d'un dispositif d'application de produit conforme à un deuxième mode de réalisation de l'invention ;
[Fig 9] La Figure 9 est une coupe schématique d'un dispositif d'application de produit conforme à un troisième mode de réalisation de l'invention ;
[Fig 10] La Figure 10 est une coupe schématique d'un dispositif d'application de produit conforme à un quatrième mode de réalisation divulgué mais non revendiqué ;
[Fig 11] La Figure 11 est une coupe schématique d'un dispositif d'application de produit conforme à un cinquième mode de réalisation divulgué mais non revendiqué.

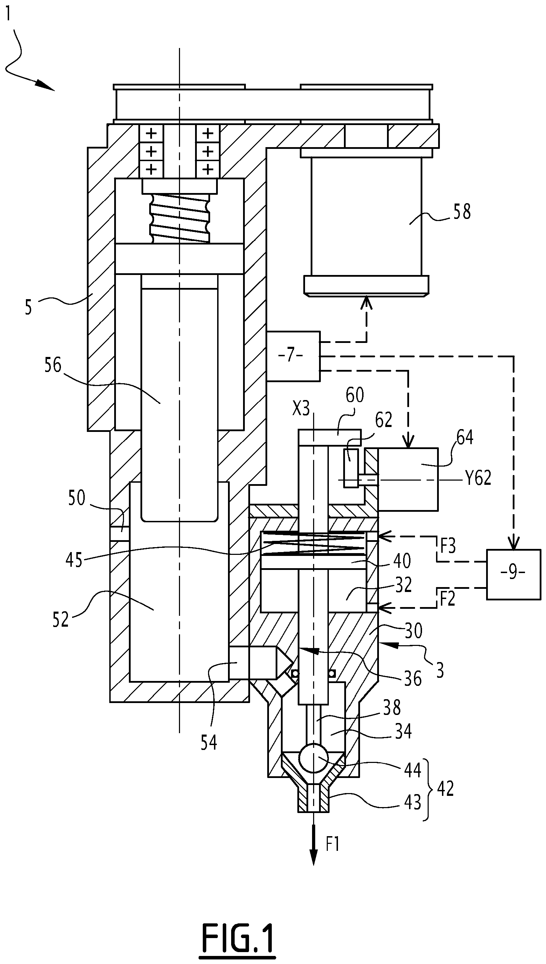

La figure 1 représente une machine divulgué mais non revendiqué d'application 1 de produit, notamment des produits à haute viscosité tels que les colles ou les produits d'étanchéité (mastic, etc.). La machine 1 comprend un dispositif d'application 3 de produit, et un système de dosage 5 du produit alimenté par une source de produit à appliquer (non représentée).

Le système de dosage 5 comprend un port 50 d'entrée de produit, une chambre 52 de dosage du produit, et un port de sortie 54 du produit vers le dispositif d'application 3. Le système de dosage 5 comprend un piston de dosage 56, et un moteur 58 actionnant le déplacement du piston de dosage 56 dans la chambre 52 par l'intermédiaire d'un système de transformation mécanique du mouvement (par exemple une vis à billes).

Le système de dosage 5 est configuré pour envoyer le produit dans le dispositif d'application 3 avec une pression réglable. La vitesse et le couple du moteur 58 sont pilotés pour régler la vitesse de déplacement du piston de dosage 56, et la pression de sortie du produit du port de sortie 54.

La machine d'application 1 comprend une unité de contrôle 7 configurée pour contrôler le système de dosage 5 et le dispositif d'application 3. L'unité de contrôle 7 peut être à cet effet équipée de microprocesseurs, de mémoires, de systèmes de calcul et de communication configurés pour contrôler le système de dosage 5 et le dispositif d'application 3 par des signaux électriques.

Le dispositif d'application 3 comprend un bâti 30 dans lequel sont prévus une chambre de pilotage 32 et un conduit de produit 34. Le bâti 30 définit un alésage longitudinal 36 centré autour d'un axe central X3, et qui traverse longitudinalement le bâti 30 à travers la chambre de pilotage 32 et rejoint le conduit 34. Le dispositif d'application 3 comprend un pointeau 38 monté dans l'alésage longitudinal 36 de façon coulissante. Le dispositif d'application 3 comprend également un piston 40 logé dans la chambre de pilotage 32 et solidaire du pointeau 38 dans son coulissement selon l'axe X3.

Le dispositif d'application 3 comprend une vanne d'application à pointeau 42, formée par une buse 43 prévue sur le bâti 30 et un obturateur 44 prévu à une extrémité du pointeau 38 située dans le conduit 34. Le conduit de produit 34 guide le produit entre le port de sortie 54 et la buse 43. Le produit est appliqué à sa sortie de la buse 43 selon la flèche F1. L'obturateur 44 est dans cet exemple formé par une bille, mais peut être de toute autre forme, notamment un cône, etc.

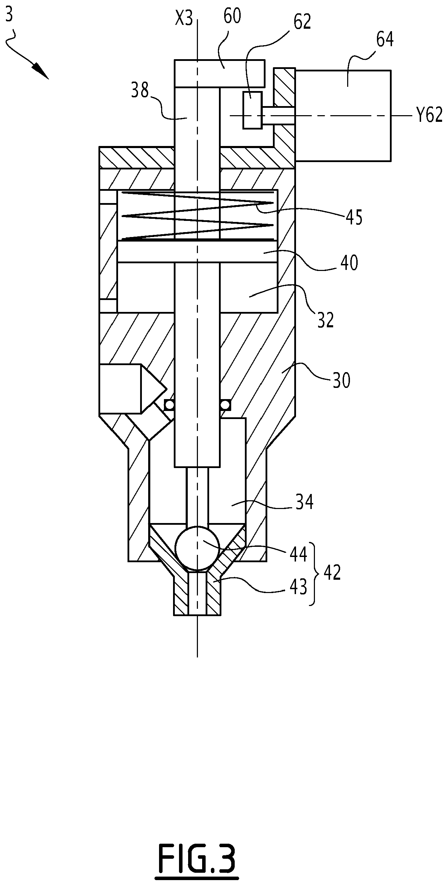

Le pointeau 38 se déplace le long de l'axe longitudinal X3 entre une position de fermeture de la vanne à pointeau 42, représentée à la figure 3, et une position d'ouverture représentée à la figure 1, sous l'action d'un fluide de pilotage injecté dans la chambre de pilotage 32. Le dispositif d'application 3 comprend un élément de rappel élastique du pointeau 38 en position fermée, formé par exemple par un ressort spiral 45, logé dans la chambre de pilotage 32. Lorsque qu'un fluide de pilotage est injecté dans la chambre de pilotage 32 selon la flèche F2, le pointeau 38 est dirigé vers sa position ouverte à l'encontre de l'effort du ressort 45. Un fluide de pilotage peut également être injecté dans la chambre de pilotage 32 selon la flèche F3, pour diriger le pointeau 38 vers sa position fermée. Le fluide de commande peut être de l'air comprimé.

Selon une variante non représentée, le pointeau 38 retourne à sa position fermée sous l'action unique du ressort 45.

Le dispositif d'application 3 comprend une butée 60 solidaire du pointeau 38, et une butée 62 solidaire du bâti 30 configurée pour limiter le retour du pointeau 38 vers sa position de fermeture à une position intermédiaire entre la position de fermeture et la position d'ouverture, par coopération avec la butée 60 solidaire du pointeau 38. La butée 60 est solidaire du pointeau 38 dans son coulissement selon l'axe longitudinal X3. La butée 62 solidaire du bâti 30 a une position réglable, c'est-à-dire que sa position selon l'axe longitudinal X3 est fixe par rapport au pointeau 38, hormis dans un intervalle de réglage de sa position selon l'axe longitudinal X3. Le réglage de la butée 62 permet d'empêcher la fermeture complète de la vanne à pointeau 42, et donc de réduire le débit de sortie de produit dans la buse 43.

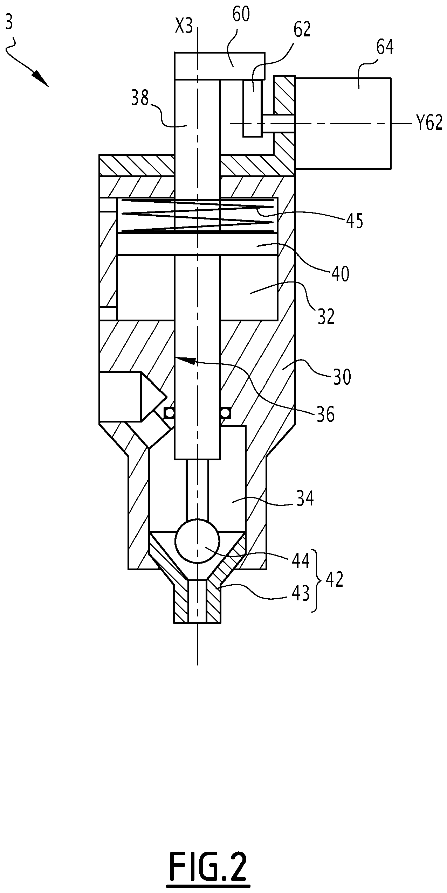

A la figure 1, la butée 62 est réglée en position haute, et le pointeau 38 est également en position haute, la vanne à pointeau 42 étant complètement ouverte. Les butées 60 et 62 ne sont pas en contact. A la figure 2, la butée 60 est en contact avec la butée 62 dans une position intermédiaire, ce qui limite le retour du pointeau 38 en position basse à une position intermédiaire, la vanne à pointeau 42 n'est donc pas complètement fermée, et une restriction de débit est donc formée. A la figure 3, la butée 62 est réglée en position basse. Cela permet le retour complet du pointeau 38 en position basse, car la butée 62 ne forme plus d'obstacle à la descente de la butée 60 selon l'axe X3. La vanne à pointeau 42 est alors complètement fermée.

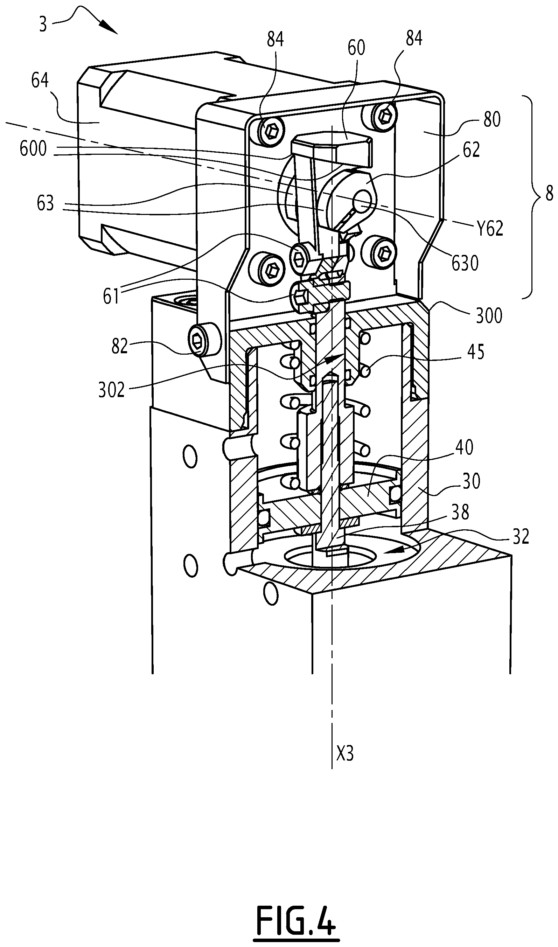

Selon un mode de réalisation divulgué mais non revendiqué représenté sur les figures 4 à 6, la butée 60 est fixée à une extrémité du pointeau 38 faisant saillie hors du bâti 30, cette extrémité étant opposée à l'obturateur 44. Le bâti 30 comporte un couvercle supérieur 300, percé d'un orifice 302 à travers lequel le pointeau 38 coulisse selon l'axe longitudinal X3. La butée 60 est fixée au pointeau 38 par exemple par deux vis 61.

Le dispositif d'application 3 comprend un actionneur 64 de réglage de la position de la butée 62. Selon un mode de réalisation, la butée 62 est formée par au moins une came 63 mobile en rotation autour d'un axe de rotation Y62 perpendiculaire à l'axe longitudinal X3. L'actionneur 64 est dans ce cas formé par un moteur électrique entraînant en rotation la came 63 autour de l'axe Y62. La rotation de la came 63 autour de l'axe Y62 permet de régler la position angulaire de la came 63 et de modifier le positionnement selon l'axe X3 de la butée 62. Le moteur électrique peut être un moteur pas-à-pas.

Comme cela est visible aux figures 4 à 6, la butée 62 peut comprendre deux cames parallèles 63, montées sur un arbre commun 630 aligné avec l'axe de réglage Y62.

Selon un mode de réalisation, la butée 60 présente une surface 600 de contact avec la butée 62 qui est inclinée par rapport à l'axe longitudinal X3. Cette surface 600 inclinée permet que la variation de la hauteur de la butée 62 selon l'axe longitudinal X3 en fonction de la position angulaire de la came 63 soit la plus constante possible, dans le but d'améliorer la précision et la simplicité du pilotage de la came 63 par l'actionneur 64. Ceci permet également de garantir que le point de contact entre la came 63 et la surface inclinée 600 s'éloigne le moins possible de l'axe longitudinal X3, tout en évitant la conception d'une surface de butée 60 spécifique.

En variante non représentée, la surface 600 peut être perpendiculaire à l'axe longitudinal X3.

La butée 60 présente deux surfaces inclinées parallèles 600 coopérant chacune avec l'une des cames 63.

La came 63 décrit une surface courbe de rayon croissant autour de l'axe Y62. La position angulaire de la came 63 autour de l'axe Y62 fait varier la position axiale, selon l'axe X3, de la butée 62, et la position intermédiaire à laquelle est limité le retour du pointeau 38 vers sa position fermée.

A la figure 4, les cames 63 sont dans une position basse, c'est-à-dire une position angulaire dans laquelle elles forment un obstacle bas, qui ne s'oppose pas à la descente de la butée 60. Le pointeau 38 peut donc être dans sa position fermée.

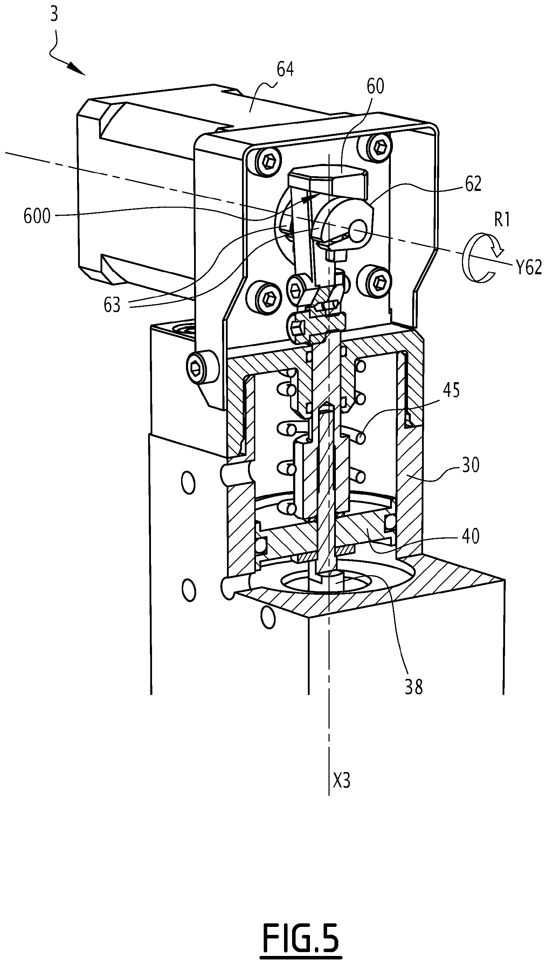

A la figure 5, les cames 63 sont dans une position intermédiaire correspondant à une position angulaire dans laquelle le rayon de la surface de came aligné avec l'axe X3 est plus grand. Les cames 63 forment un obstacle situé plus haut le long de l'axe longitudinal X3 par rapport à la figure 4. Entre la figure 4 et la figure 5, les cames 63 ont subi une rotation selon la flèche R1 à la figure 5. Dans cette position des cames 63, la butée 60 est arrêtée à une position plus élevée, empêchant la vanne à pointeau 42 de se refermer et créant une restriction de débit au niveau de la buse 43.

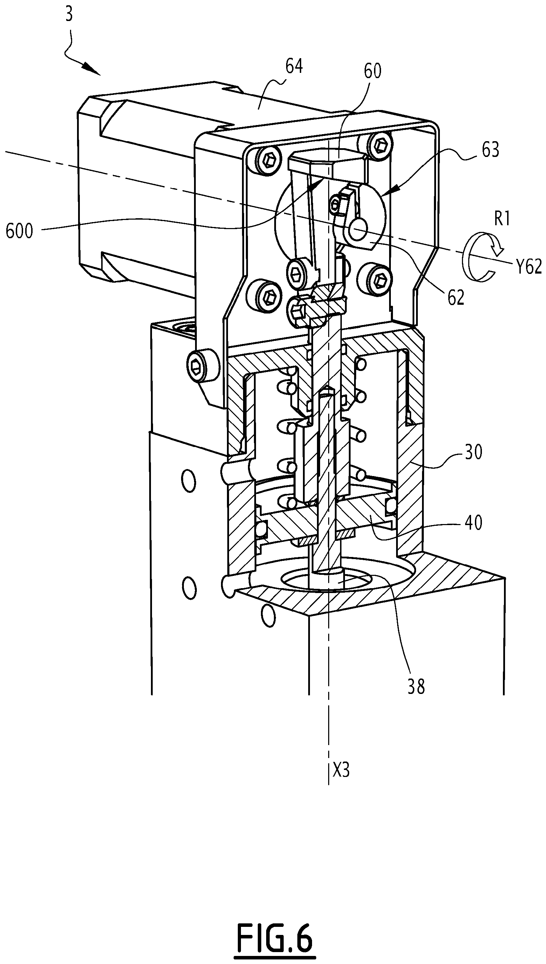

A la figure 6, les cames 63 ont été positionnées à une position angulaire dans laquelle le rayon de surface de came aligné avec l'axe X3 est maximal. La rotation des cames 63 selon l'axe Y62 s'est poursuivie selon la flèche R1. Dans cette position, la butée 62 retient la butée 60 dans une position haute, dans laquelle l'ouverture de la vanne à pointeau 42 est maximale.

Selon un mode de réalisation, l'actionneur de réglage 64, la butée 60 et la butée 62 forment un ensemble externe 8 configuré pour être fixé et relié au bâti 30 et au pointeau 38 d'un dispositif d'application 3 existant. Cet ensemble comporte un capot 80 qui renferme la butée 60 et la butée 62, et qui est fixé au couvercle supérieur 300, par exemple par des vis 82. L'actionneur 64 est fixé au capot 80, par exemple par des vis 84. Sous la forme de l'ensemble externe 8, les butées 60 et 62 et l'actionneur 64 peuvent être facilement adaptés à un dispositif d'application existant, la seule contrainte étant un accès extérieur au pointeau 38. Cet accès est peu contraignant en comparaison des solutions techniques spécifiques nécessaires pour garantir l'étanchéité, la modification de la vanne à pointeau, et la puissance des actionneurs dans le cas des solutions actuelles mentionnées précédemment.

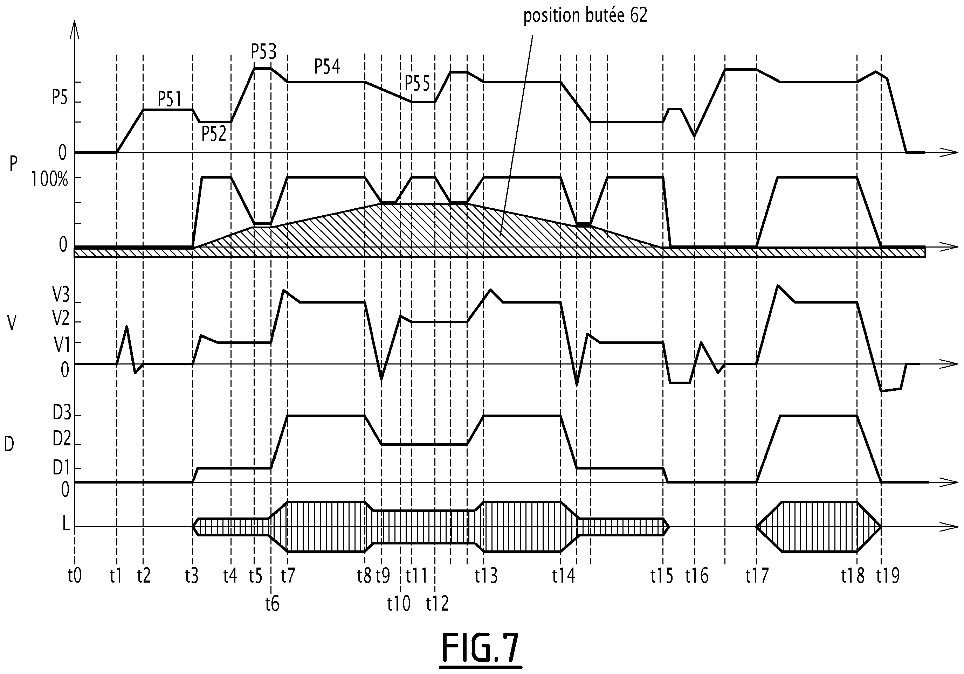

Le fonctionnement de la machine 1 est décrit en référence à la figure 7.

La figure 1 présente en abscisse le temps, et en ordonnées, de bas en haut :
- La largeur L du cordon de produit déposé par le dispositif d'application 3 ;
- Le débit de sortie D de la buse 43 ;
- La vitesse angulaire V du moteur 58 représentative de la vitesse linéaire du piston 56;
- La position P du pointeau 38, avec sous forme d'aire hachurée, la position de la butée 62 solidaire du bâti 30 ;
- La pression relative à la pression atmosphérique P5 de produit présente en sortie du système de dosage 5.

A un temps t0, par exemple correspondant à l'allumage de la machine 1, le débit de sortie D, la vitesse V et la pression P5 sont nuls, et le pointeau 38 est en position fermée. La butée 62 est dans sa position des figures 3 et 4, c'est-à-dire n'empêche pas le retour du pointeau 38 en position fermée.

Pour obtenir un premier cordon de produit, il est nécessaire d'avoir une certaine pression P5 dans le dispositif d'application 3 légèrement supérieure à la pression d'application souhaitée après ouverture de la vanne à pointeau 42. On applique donc une pré-charge initiale. Cette pré-charge est obtenue en actionnant rapidement le moteur 58. La vitesse V est donc augmentée à un temps t1, puis revient à zéro à un temps t2, le pointeau 38 restant en position et la vanne à pointeau 42 restant donc fermée afin d'obtenir une pression P51.

A un temps t3, la dépose de produit commence : le pointeau 38 est déplacé pour ouvrir la vanne à pointeau 42 à 100%. La vitesse V est augmentée pour générer une pression de produit constante P52, et un débit de sortie D1, correspondant à une fraction, par exemple 10%, d'une valeur maximale D3 du débit de sortie D. La butée 62 reste en position basse.

Les butées 60 et 62 sont mises en oeuvre dans des phases transitoires du fonctionnement de la machine 1, lorsqu'une augmentation ou une diminution du débit de sortie de la buse 43 doit être obtenu.

Une demande d'augmentation du débit de sortie D à un temps t6 est requise. Le débit doit être augmenté rapidement entre D1 et D3. Pour cela, en avance du temps t6, on génère une augmentation de la pression de sortie P5 par le maintien à une valeur constante V1 de la vitesse V et la réduction de l'ouverture de la vanne à pointeau 42. Pour cela, la butée 62 est progressivement déplacée à une position prédéfinie, pendant que la machine 1 régule le débit de sortie D à la valeur D1. Le positionnement de la butée 62 débute à t3. La position prédéfinie de la butée 62 peut par exemple correspondre à une ouverture faible de la vanne à pointeau 42, par exemple de 10% de l'ouverture maximale.

A un temps t4, la fermeture de la vanne à pointeau 42 est initiée. A un temps t5, la butée 62 a atteint sa position prédéfinie, et le pointeau 38 atteint jusqu'à la position prédéfinie par le positionnement de la butée 62. Une restriction de débit au niveau de la buse 43 est donc formée. La vitesse V étant maintenue constante à V1, ceci a pour effet d'augmenter la pression P5 jusqu'à une valeur P53 au temps t5. L'obtention d'un débit plus important nécessite une seconde pré-charge préalable, tout en maintenant constant le débit de sortie D.

Au temps t6, la pression P53 nécessaire étant obtenue, la vanne à pointeau 42 est à nouveau ouverte à 100%. La vitesse V est augmentée à une valeur maximale V3 pour atteindre la valeur nécessaire à l'obtention du débit de sortie D3. A un temps t7, l'ouverture de la vanne à pointeau 42 est de 100%, la vitesse V3 est obtenue, la pression P5 a diminué à une valeur P54 du fait de l'ouverture de la vanne à pointeau 42, et le débit D3 est obtenu. Le temps d'obtention de l'augmentation de débit de sortie D, entre les temps t6 (ouverture de la vanne à pointeau 42) et t7 (obtention du débit D3), est court, par exemple de l'ordre de quelques ms, ce qui permet d'avoir une augmentation de largeur de cordon nette. Si une telle rapidité devait être obtenue avec des actionneurs pilotant une restriction mécanique au niveau de la buse 43, ceux-ci devraient alors être très puissants et coûteux.

A l'inverse, le positionnement de la butée 62 peut être réalisé en temps masqué pendant une phase de régulation normale. Il n'est donc pas nécessaire de prévoir un actionneur puissant pour son déplacement. Entre le temps t3 et le temps t6, quelques dizaines de ms peuvent être suffisants pour positionner la butée 62. C'est un temps de commutation qui reste compatible avec un moteur pas-à-pas standard, peu coûteux, qui peut donc être utilisé pour l'actionneur 64.

Une phase transitoire de diminution du débit de sortie D est à présent décrite. Le débit de sortie D doit être diminué à une valeur intermédiaire D2 inférieure à D3, par exemple 20% du débit D3. Pour cela, l'unité de contrôle 7 génère une réduction de pression de sortie P5. Cette réduction de pression est rapide : la vitesse V est rapidement réduite à une valeur basse. Par exemple, la vitesse V est réduite à la valeur basse en quelques ms. La réduction de vitesse V débute à un temps t8 et se termine à un temps t9. La valeur basse à laquelle est réduite la vitesse V peut être inférieur à zéro comme illustré au temps t9 à la figure 7, le sens de marche du moteur 58 peut donc être inversé, dans les cas où une forte réduction de débit est souhaitée. En variante, la valeur basse peut être une vitesse nulle, ou bien par exemple une vitesse inférieure à 10 % de la valeur maximale de la vitesse V, par exemple lorsque la variation de débit souhaitée est moins brusque.

Simultanément, l'ouverture de la vanne à pointeau 42 est réduite. Cette réduction d'ouverture est obtenue en positionnant la butée 62 à une position intermédiaire prédéfinie correspondant par exemple à 20% de l'ouverture totale de la vanne à pointeau 42, et en fermant, au temps t8, la vanne à pointeau 42 en actionnant le pointeau 38 vers la position fermée jusqu'à ce qu'il soit bloqué par la butée 62 à la position prédéfinie à 20%, au temps t9. Le début du positionnement de la butée 62 a lieu préalablement au temps t8, et peut par exemple démarrée à partie de la position à 10% d'ouverture, au temps t6, de manière que l'actionneur 64 ait suffisamment de temps pour positionner la butée 62. On obtient ainsi une réduction rapide du débit de sortie D. On entre ensuite dans une phase de régulation normale du débit de sortie D à la valeur D2. Pour cela, la vanne à pointeau 42 est ouverte à nouveau à un temps t10, et la vitesse V est à nouveau augmentée à partir du temps t9 jusqu'à une valeur V2 nécessaire à l'obtention du débit de sortie D2. A un temps t11, la vitesse V est stabilisée, la pression P5 est stabilisée à une valeur P55, et le pointeau 38 est positionné à sa position d'ouverture à 100%.

Entre les temps t12 et t13 sont opérés à nouveau par l'unité de contrôle 7 les étapes déjà décrites pour l'augmentation du débit de sortie D entre D1 et D3: afin de rétablir le débit de sortie D à D3, la vitesse V est maintenue constante, et la pression P5 est à nouveau augmentée à la valeur P53 par la fermeture partielle de la vanne à pointeau 42 jusqu'à la valeur d'ouverture intermédiaire fixée par le positionnement de la butée 62, qui est restée en place. A t13, un régime de régulation normal s'établit avec le débit de sortie D à D3.

A des temps ultérieurs t14 et t15 sont à nouveau opérées des réductions rapides de la vitesse V et des fermetures partielles de la vanne à pointeau 42 pour obtenir successivement une réduction du débit de sortie D à D1, puis à zéro. Au temps t13, ou bien un peu avant, la butée 62 a été progressivement descendue pour fixer à t14 une position d'arrêt du pointeau 38 correspondant à l'ouverture faible de la vanne à pointeau 42, par exemple 10%. Après le temps t14, la butée 62 a été progressivement descendue jusqu'à sa position basse pour permettre la fermeture complète de la vanne à pointeau 42 à t15, et la fin du cordon de produit. Au temps t15, la vitesse V est brutalement réduite jusqu'à une valeur négative, ce qui revient à retirer le piston 56 vers le haut, pour obtenir une rapide décompression dans le conduit 34 du dispositif d'application 3.

Le procédé de contrôle peut ensuite être repris tel qu'il a commencé à t0, par une nouvelle pré-charge par l'augmentation de la vitesse V à t16. Un nouveau cordon de produit peut ensuite être déposé, avec le débit de sortie D3, à t17. A un temps t18, la vitesse V est brutalement inversée, pour obtenir une décompression rapide et la fin du cordon de produit à t19. Dans la mesure où il n'y a pas de variations du débit de sortie D entre des valeurs intermédiaires entre t17 et t19, la butée 62 n'est pas utilisée dans cette phase. Le dispositif d'application 3 équipé des butées 60 et 62 peut donc fonctionner dans un cas d'utilisation classique.

Toutes les étapes de fonctionnement décrites ci-dessus sont déclenchées au niveau de l'unité de contrôle 7 par des signaux de contrôle envoyés au moteur 58, à un distributeur 9 de fluide de pilotage contrôlant le déplacement du pointeau 38, par exemple un distributeur pneumatique, et à l'actionneur 64.

L'invention procure les avantages suivants :
- Les fermetures complètes de la vanne à pointeau 42 sont rapides lorsque la butée 62 est en position basse, et il n'y a pas de création de volume mort de produit entre l'amont de la buse 43 et la buse 43. Les fins de cordons de produit sont donc nettes.
- Il n'y a pas de création d'usures spécifiques dues à des pièces mobiles supplémentaires au niveau de la buse 43 : La vanne à pointeau 42 aura donc une longévité normale.
- L'actionneur 64 n'a pas besoin d'être puissant, car les pré-positionnements de la butée 62 sont faits en temps masqué pendant des durées plus longues que les changements brusques de débit de sortie de produit. En outre, les positionnements de la butée 62 sont faits pendant que la vanne à pointeau 42 est ouverte, ce qui ne génère pas d'efforts sur la came de la butée 62.
- Les systèmes d'étanchéités conventionnels de la vanne à pointeau 42 peuvent être utilisés, et il n'y a pas de nécessité de concevoir des systèmes d'étanchéité spécifiques.
- Les butées 60 et 62 ainsi que l'actionneur 64 peuvent être adaptés sous la forme de l'ensemble 8 sur un dispositif d'application préexistant en prévoyant seulement un accès au pointeau 38 ou au piston 40.

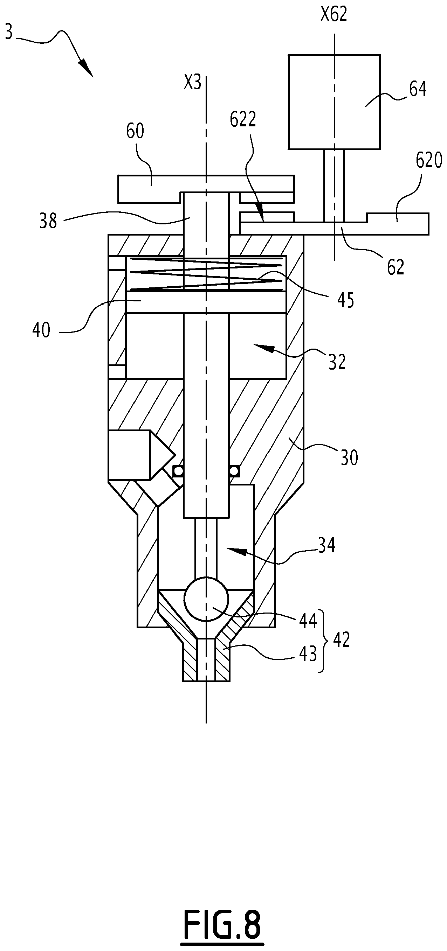

D'autres modes de réalisation du dispositif d'application de produit sont représentés sur les figures 8 à 11. Dans ces modes de réalisation, les éléments communs au premier mode de réalisation portent les mêmes références et fonctionnent de la même manière.

Un deuxième mode de réalisation selon l'invention est représenté sur la figure 8. Dans ce mode de réalisation, la position de la butée 62 solidaire du bâti 30 est réglable autour d'un axe de réglage X62 parallèle à l'axe longitudinal X3 du pointeau 38. La butée est formée par une surface de came 620 dont la hauteur, selon l'axe X62, est variable en fonction de sa position angulaire autour de l'axe X62. Sur une portion angulaire, la surface de came 620 présente un décrochement 622 de faible épaisseur qui n'empêche pas la descente du pointeau 38. Sur une portion angulaire opposée par rapport à l'axe X62, la surface de came 620 présente une épaisseur maximale, qui forme une limitation au retour en position fermée du pointeau 38.

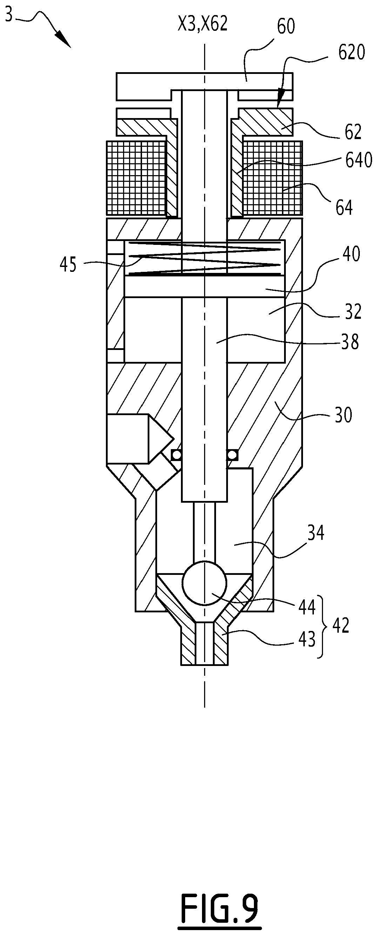

Un troisième mode de réalisation selon l'invention est représenté sur la figure 9. Dans ce mode de réalisation, l'actionneur 64 est un moteur à axe creux formant une pièce tubulaire 640 montée de façon rotative autour d'une partie du pointeau 38 faisant saillie hors du bâti 30. Cette pièce tubulaire 640 porte la butée 62, qui présente une surface de came 620 similaire à celle du mode de réalisation de la figure 8. Dans ce cas, la position angulaire de la surface de came 620 est réglable autour de l'axe longitudinal X3 du pointeau 38, l'axe de réglage X64 et l'axe longitudinal X3 étant confondus. La hauteur selon l'axe longitudinal X3 de la surface de came 620 est variable autour de l'axe de réglage X64. Ce mode de réalisation garantit une compacité radiale et axiale du dispositif d'application 3.

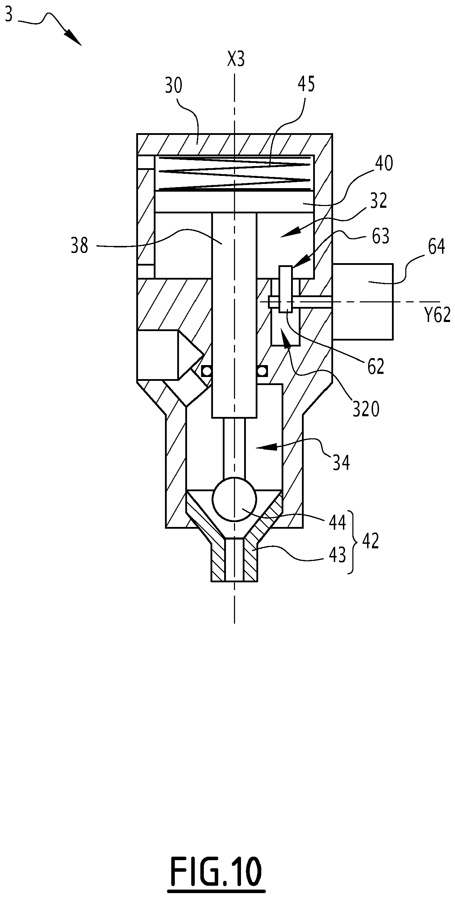

Un quatrième mode de réalisation divulgué mais non revendiqué est représenté sur la figure 10. Dans ce mode de réalisation, la butée 62 solidaire du bâti 30 est prévue dans la chambre de pilotage 32. La came 63 formant la butée 63 est mobile en rotation autour de l'axe de réglage Y62 orienté perpendiculairement à l'axe longitudinal X3. La came 63 fait saillie dans la chambre de pilotage 32 de manière à limiter la translation du piston 40 vers le bas. Dans ce cas, la butée solidaire du pointeau 38 est donc formée par le piston 40 lui-même. Une cavité 320 est prévue dans le bâti 30 pour permettre la rotation de la came 63 autour de l'axe de réglage Y62.

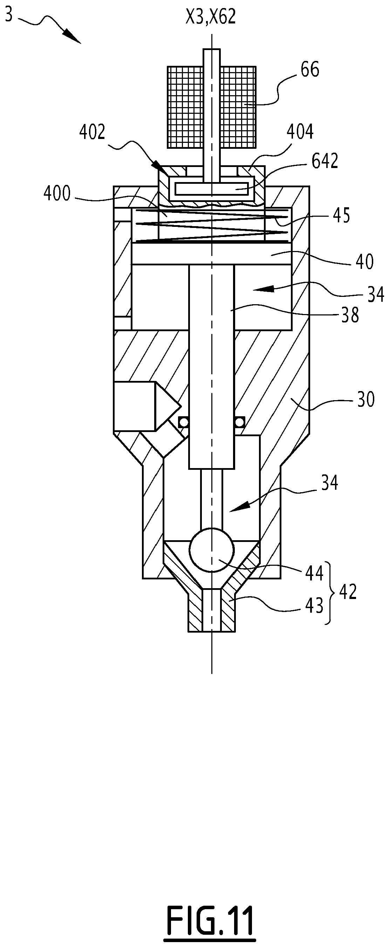

Un cinquième mode de réalisation divulgué mais non revendiqué est représenté sur la figure 11. Dans ce mode de réalisation, l'actionneur de réglage est un actionneur linéaire 66, c'est-à-dire exerçant un déplacement en translation, par exemple un vérin ou une vis à billes. La butée 62 solidaire du bâti 30 est formée par une pièce 642 mobile en translation selon l'axe de réglage X62 qui est alors parallèle ou confondu avec l'axe longitudinal X3 du pointeau 38. Le piston 40 comporte une partie cylindrique 400 s'étendant en saillie en dehors du bâti 30, et autour de laquelle s'enroule le ressort 45. La partie cylindrique 400 comprend à son extrémité supérieure une cavité 402 dans laquelle est reçue la pièce 642. La cavité 402 comprend une partie radiale 404 orientée vers l'intérieur, qui forme la butée 60 solidaire du pointeau 38. Lorsque le pointeau 38 retourne vers sa position fermée, la pièce 642 s'oppose selon l'axe longitudinal X3 à la partie radiale 404 et limite la fermeture de la vanne à pointeau 42.

Les caractéristiques techniques des modes de réalisation et variantes décrits ci-dessus peuvent être combinées pour former d'autres modes de réalisation de l'invention dans le cadre des revendications.

## Revendications

1. Dispositif d'application (3) de produit, comprenant un bâti (30) dans lequel est prévu un conduit (34) de produit, le bâti (30) définissant un alésage longitudinal (36), le dispositif d'application (3) comprenant un pointeau (38) monté dans l'alésage longitudinal (36), le dispositif d'application comprenant une vanne d'application (42) de produit formée par une buse (43) prévue sur le bâti (30) et un obturateur (44) prévu à une extrémité du pointeau (38) située dans le conduit (34) de produit, le pointeau étant configuré pour être déplacé le long d'un axe longitudinal (X3) entre une position de fermeture de la vanne d'application (42) et une position d'ouverture, dans lequel le dispositif d'application (3) comprend une butée (60 ; 40) solidaire du pointeau (38), et une butée (62) solidaire du bâti (30) configurée pour limiter le retour du pointeau (38) vers sa position de fermeture à une position intermédiaire entre la position de fermeture et la position d'ouverture, par coopération avec la butée (60 ; 40) solidaire du pointeau (38), la butée (62) solidaire du bâti (30) ayant une position réglable, la butée (62) solidaire du bâti (30) étant formée par au moins une came (63), le dispositif d'application (3) comprenant un actionneur (64) de réglage de la position de la came (63), **caractérisé en ce que** la position de la came (63) est réglable en rotation autour d'un axe de réglage (X62) parallèle à l'axe longitudinal (X3) du pointeau (38), et **en ce que** l'épaisseur de la came est croissante autour de l'axe de réglage.

2. Dispositif d'application selon la revendication 1, **caractérisé en ce que** l'actionneur de réglage (64) est un moteur électrique rotatif.

3. Dispositif d'application selon la revendication 2, **caractérisé en ce que** la came est portée par une pièce tubulaire (640) montée autour d'une partie du pointeau (38) faisant saillie hors du bâti (30), **en ce que** l'actionneur (64) est un moteur à axe creux entrainant la pièce tubulaire (640), la position angulaire de la came étant réglable autour de l'axe longitudinal (X3) du pointeau (38), et **en ce que** l'épaisseur de la came est croissante autour de l'axe de réglage.

4. Dispositif d'application selon l'une des revendications précédentes, **caractérisé en ce que** la butée (60) solidaire du pointeau (38) est fixée à une extrémité du pointeau (38) faisant saillie hors du bâti (30).

5. Dispositif d'application selon la revendication 4, **caractérisé en ce que** l'actionneur de réglage (64), la butée (60) solidaire du pointeau (38) et la butée (62) solidaire du bâti (30) forment un ensemble externe (8) configuré pour être fixé et relié au bâti (30) et au pointeau (38) d'un dispositif d'application (3) existant.

6. Dispositif d'application selon l'une des revendications 1 à 3, **caractérisé en ce que** la butée solidaire du pointeau (38) est formée par un piston (40) logé dans une chambre de pilotage (32) du bâti (30), et **en ce que** la butée (62) solidaire du bâti (30) est prévue dans le bâti (30) et fait saillie dans la chambre de pilotage (32).

7. Dispositif d'application selon l'une des revendications précédentes, **caractérisé en ce que** la butée (60) solidaire du pointeau (38) présente une surface (600) inclinée par rapport à l'axe longitudinal (X3) du pointeau (38).

8. Machine d'application (1) de produit comprenant : un dispositif d'application (3) selon l'une des revendications précédentes, et un système de dosage (5) du produit, le système de dosage (5) étant configuré pour envoyer le produit avec une pression réglable (P5) dans le dispositif d'application (3), le système de dosage (5) comprenant un moteur (58) dont la vitesse (V) est pilotée pour régler la pression (P5) et une unité de contrôle (7) configurée pour contrôler le système de dosage (5) et le dispositif d'application (3).

9. Procédé de contrôle d'une machine d'application (1) de produit selon la revendication 8, **caractérisé en ce qu'**il comprend au moins l'une des étapes suivantes, mises en oeuvre par l'unité de contrôle (7) et consistant à :
- a) en cas de demande d'augmentation d'un débit de sortie (D) de buse (43) du dispositif d'application (3) entre une valeur inférieure (D1) et une valeur supérieure (D3), générer une augmentation de pression de sortie (P5) du système de dosage (5) par le maintien à une valeur constante (V1, V2) de la vitesse du moteur (58) du système de dosage (5) et la réduction de l'ouverture de la vanne à pointeau (42) du dispositif d'application (3), puis rouvrir la vanne à pointeau (42) et augmenter la vitesse du moteur (58) jusqu'à la valeur (V3) nécessaire à l'obtention de la valeur supérieure de débit de sortie (D);
- b) en cas de demande de diminution du débit de sortie (D) entre la valeur supérieure (D3) et la valeur inférieure (D1) ou à une valeur intermédiaire (D2) entre la valeur inférieure et la valeur supérieure, générer une réduction de pression de sortie (P5) du système de dosage (5) par la réduction de la vitesse du moteur (58) à une valeur basse, et la réduction de l'ouverture de la vanne à pointeau (42) du dispositif d'application (3), puis rouvrir la vanne à pointeau (42) et augmenter la vitesse (V) du moteur (58) jusqu'à la valeur (V2) nécessaire à l'obtention de la valeur intermédiaire ou de la valeur inférieure de débit de sortie (D).

10. Procédé de contrôle selon la revendication 9, **caractérisé en ce qu'**aux étapes a) et b), la réduction de l'ouverture de la vanne à pointeau (42) du dispositif d'application (3) est obtenue par le positionnement de la butée (62) solidaire du bâti (30) à une position prédéfinie pendant une phase de régulation du débit de sortie (D), puis la fermeture de la vanne à pointeau (42) jusqu'à la position prédéfinie par le positionnement de la butée (62) solidaire du bâti (30).

11. Procédé de contrôle selon la revendication 9 ou 10, **caractérisé en ce qu'**à l'étape b), la valeur basse à laquelle est réduite la vitesse (V) du moteur (58) est inférieure à zéro, le sens de marche du moteur (58) étant inversé.

## Patentansprüche

1. Vorrichtung zum Auftragen (3) eines Produkts, die einen Rahmen (30) umfasst, in dem eine Produktleitung (34) vorgesehen ist, wobei der Rahmen (30) eine Längsbohrung (36) definiert, wobei die Vorrichtung zum Auftragen (3) eine Nadel (38) umfasst, die in der Längsbohrung (36) angebracht ist, wobei die Vorrichtung zum Auftragen ein Produktauftragsventil (42) umfasst, das durch eine Düse (43) gebildet wird, die an dem Rahmen (30) vorgesehen ist und einen Verschluss (44), der an einem Ende der Nadel (38) vorgesehen ist, das sich in der Produktleitung (34) befindet, wobei die Nadel so konfiguriert ist, dass sie entlang einer Längsachse (X3) zwischen einer Schließstellung des Auftragventils (42) und einer Öffnungsstellung bewegt werden kann, wobei die Vorrichtung zum Auftragen (3) einen Anschlag (60; 40) umfasst, der fest mit der Nadel (38) verbunden ist, und einen Anschlag (62), der fest mit dem Rahmen (30) verbunden ist und so konfiguriert ist, dass er die Rückkehr der Nadel (38) in ihre Schließstellung in eine Zwischenstellung zwischen der Schließstellung und der Öffnungsstellung durch Zusammenwirken mit dem Anschlag (60, 40) begrenzt, der fest mit der Nadel (38) verbunden ist, wobei der mit dem Rahmen (30) fest verbundene Anschlag (62) eine einstellbare Position hat, wobei der mit dem Rahmen (30) fest verbundene Anschlag (62) durch mindestens einen Nocken (63) gebildet wird, wobei die Applikationsvorrichtung (3) einen Stellantrieb (64) zur Einstellung der Position des Nockens (63) umfasst, **dadurch gekennzeichnet, dass** die Position des Nockens (63) um eine Einstellachse (X62) drehbar ist, die parallel zur Längsachse (X3) der Nadel (38) verläuft, und dass die Dicke des Nockens um die Einstellachse herum zunimmt.

2. Vorrichtung zum Auftragen nach Anspruch 1, **dadurch gekennzeichnet, dass** der Stellantrieb (64) ein rotierender Elektromotor ist.

3. Vorrichtung zum Auftragen nach Anspruch 2, **dadurch gekennzeichnet, dass** der Nocken von einem rohrförmigen Teil (640) getragen wird, das um einen Teil der Nadel (38) herum montiert ist, der aus dem Rahmen (30) herausragt, dass der Stellantrieb (64) ein Motor mit einer Hohlwelle ist, die das rohrförmige Teil (640) antreibt, wobei die Winkelposition des Nockens um die Längsachse (X3) der Nadel (38) einstellbar ist, und die Dicke des Nockens um die Einstellachse zunimmt.

4. Vorrichtung zum Auftragen nach einem der vorhergehenden Ansprüche, **dadurch gekennzeichnet, dass** der mit der Nadel (38) fest verbundene Anschlag (60) an einem Ende der Nadel (38) befestigt ist, das aus dem Rahmen (30) herausragt.

5. Vorrichtung zum Auftragen nach Anspruch 4, **dadurch gekennzeichnet, dass** der Stellantrieb (64), der Anschlag (60), der fest mit der Nadel (38) verbunden ist, und der Anschlag (62), der fest mit dem Rahmen (30) verbunden ist, eine externe Baugruppe (8) bilden, die so konfiguriert ist, dass sie an dem Rahmen (30) und der Nadel (38) einer bestehenden Vorrichtung zum Auftragen (3) befestigt und mit diesen verbunden werden kann.

6. Vorrichtung zum Auftragen nach einem der Ansprüche 1 bis 3, **dadurch gekennzeichnet, dass** der mit der Nadel (38) fest verbundene Anschlag durch einen Kolben (40) gebildet wird, der in einer Steuerkammer (32) des Rahmens (30) angeordnet ist, und dass der mit dem Rahmen (30) fest verbundene Anschlag (62) in dem Rahmen (30) vorgesehen ist und in die Steuerkammer (32) vorsteht.

7. Vorrichtung zum Auftragen nach einem der vorhergehenden Ansprüche, **dadurch gekennzeichnet, dass** der Anschlag (60), der fest mit der Nadel (38) verbunden ist, eine Oberfläche (600) aufweist, die in Bezug auf die Längsachse (X3) der Nadel (38) geneigt ist.

8. Maschine zum Auftragen (1) eines Produkts, umfassend: eine Vorrichtung zum Auftragen (3) nach einem der vorhergehenden Ansprüche und einem Dosiersystem (5) für das Produkt, wobei das Dosiersystem (5) so konfiguriert ist, dass es das Produkt mit einem einstellbaren Druck (P5) in die Vorrichtung zum Auftragen (3) leitet, wobei das Dosiersystem (5) einen Motor (58), dessen Geschwindigkeit (V) gesteuert wird, um den Druck (P5) einzustellen, und eine Steuereinheit (7) umfasst, die so konfiguriert ist, dass sie das Dosiersystem (5) und die Vorrichtung zum Auftragen (3) steuert.

9. Verfahren zur Steuerung einer Maschine zum Auftragen (1) eines Produkts nach Anspruch 8, **dadurch gekennzeichnet, dass** es mindestens einen der folgenden Schritte umfasst, die von der Steuereinheit (7) ausgeführt werden und in Folgendem bestehen:
- a) im Falle einer Anforderung zur Erhöhung einer Ausgaberate (D) der Düse (43) der Vorrichtung zum Auftragen (3) zwischen einem unteren Wert (D1) und einem oberen Wert (D3), eine Erhöhung des Ausgabedrucks (P5) des Dosiersystems (5) erzeugen, indem die Geschwindigkeit des Motors (58) des Dosiersystems (5) auf einem konstanten Wert (V1, V2) gehalten wird und die Verringerung der Öffnung des Nadelventils (42) der Vorrichtung zum Auftragen (3), dann erneutes Öffnen des Nadelventils (42) und Erhöhen der Geschwindigkeit des Motors (58) auf den Wert (V3), der erforderlich ist, um den höheren Wert der Ausgaberate (D) zu erhalten;
- b) im Falle einer Anforderung, die Ausgaberate (D) zwischen dem oberen Wert (D3) und dem unteren Wert (D1) oder auf einen Zwischenwert (D2) zwischen dem unteren Wert und dem oberen Wert zu verringern, eine Verringerung des Ausgangsdrucks (P5) des Dosiersystems (5) zu erzeugen, indem die Drehzahl des Motors (58) auf einen niedrigen Wert verringert wird und die Verringerung der Öffnung des Nadelventils (42) der Vorrichtung zum Auftragen (3), dann erneutes Öffnen des Nadelventils (42) und Erhöhen der Geschwindigkeit (V) des Motors (58) auf den Wert (V2), der zum Erreichen des mittleren oder unteren Werts der Ausgaberate (D) erforderlich ist.

10. Steuerungsverfahren nach Anspruch 9, **dadurch gekennzeichnet, dass** in den Schritten a) und b) die Reduzierung der Öffnung des Nadelventils (42) der Vorrichtung zum Auftragen (3) durch Positionierung des mit dem Rahmen (30) fest verbundenen Anschlags (62) auf eine vordefinierte Position während einer Phase der Regulierung der Ausgaberate (D) erreicht wird und dann das Schließen des Nadelventils (42) bis zu der vordefinierten Position durch die Positionierung des mit dem Rahmen (30) fest verbundenen Anschlags (62) erreicht wird.

11. Steuerungsverfahren nach Anspruch 9 oder 10, **dadurch gekennzeichnet, dass** in Schritt b) der niedrige Wert, auf den die Geschwindigkeit (V) des Motors (58) reduziert wird, kleiner als null ist, wobei die Laufrichtung des Motors (58) umgekehrt wird.

## Claims

1. A device for applying a product (3), comprising a frame (30) in which a product conduit (34) is provided, the frame (30) defining a longitudinal bore (36), the application device (3) comprising a needle (38) mounted in the longitudinal bore (36), the application device comprising a product application valve (42) formed by a nozzle (43) provided on the frame (30) and a shutter (44) provided at one end of the needle (38) located in the product conduit (34), the needle being configured so as to be moved along a longitudinal axis (X3) between a position in which the application valve (42) is closed and a position in which it is open, wherein the application device (3) comprises a stop (60; 40) fixed in relation to the needle (38), and a stop (62), fixed in relation to the frame (30), configured to limit the return of the needle (38) to its closed position to an intermediate position between the closed position and the open position, by interaction with the stop (60; 40) fixed in relation to the needle (38), the stop (62) fixed in relation to the frame (30) having an adjustable position, the stop (62) fixed in relation to the frame (30) being formed by at least one cam (63), the application device (3) comprising an actuator (64) for adjusting the position of the cam (63), **characterized in that** the position of the cam (63) is rotatably adjustable about an adjustment axis (X62) parallel to the longitudinal axis (X3) of the needle (38), and **in that** the cam thickness increases around the adjustment axis.

2. The application device according to claim 1, **characterized in that** the adjustment actuator (64) is a rotary electric motor.

3. The application device according to claim 2, **characterized in that** the cam is carried by a tubular part (640) mounted around a portion of the needle (38) projecting from the frame (30), **in that** the actuator (64) is a hollow shaft motor driving the tubular part (640), the angular position of the cam being adjustable around the longitudinal axis (X3) of the needle (38), and **in that** the cam thickness increases around the adjustment axis.

4. The application device according to one of the preceding claims, **characterized in that** the stop (60) fixed in relation to the needle (38) is fixed to an end of the needle (38) projecting from the frame (30).

5. The application device according to claim 4, **characterized in that** the actuator (64), the stop (60) fixed in relation to the needle (38) and the stop (62) fixed in relation to the frame (30) form an external assembly (8) configured to be fixed and connected to the frame (30) and to the needle (38) of an existing application device (3).

6. The application device according to any one of claims 1 to 3, **characterized in that** the stop fixed in relation to the needle (38) is formed by a piston (40) accommodated in a control chamber (32) of the frame (30), and **in that** the stop (62) fixed in relation to the frame (30) is provided in the frame (30) and projects into the control chamber (32).

7. The application device according to one of the preceding claims, **characterized in that** the stop (60) fixed in relation to the needle (38) has a surface (600) with a bias with respect to the longitudinal axis (X3) of the needle (38).

8. A machine (1) for applying a product comprising: an application device (3) according to one of the preceding claims and a dosing system (5) for the product, the dosing system (5) being configured to send the product with an adjustable pressure (P5) into the application device (3), the dosing system (5) comprising a motor (58), the speed (V) of which is controlled in order to adjust the pressure (P5), and a control unit (7) configured to control the dosing system (5) and the application device (3).

9. A method for controlling a product application machine (1) according to claim 8, **characterized in that** it comprises at least one of the following steps, implemented by the control unit (7) and consisting in:
- a) in the event of a request to increase an output flow rate (D) of the nozzle (43) of the application device (3) between a lower value (D1) and an upper value (D3), generating an increase in output pressure (P5) of the dosing system (5) by maintaining the speed of the motor (2) at a constant value (V1, V2) of the speed of the motor (58) of the dosing system (5) and reducing the opening of the needle valve (42) of the application device (3), then reopening the needle valve (42) and increasing the speed of the motor (58) up to the value (V3) necessary to obtain the higher value of the output flow (D);
- b) in the event of a request to decrease the output flow rate (D) between the upper value (D3) and the lower value (D1) or to an intermediate value (D2) between the lower value and the upper value, generating a reduction in the output pressure (P5) of the dosing system (5) by reducing the speed of the motor (58) to a low value and reducing the opening of the needle valve (42) of the application device (3), then reopening the needle valve (42) and increasing the speed (V) of the motor (58) to the value (V2) necessary to achieve the intermediate or lower value of the output flow (D).

10. The control method according to claim 9, **characterized in that** the reduction of the opening of the needle valve (42) of the application device (3), in steps a) and b), is achieved by positioning the stop (62) fixed in relation to the frame (30) to a predefined position during a phase of regulation of the output flow rate (D), and then closing the needle valve (42) to the predefined position by positioning the stop (62) fixed in relation to the frame (30).

11. The control method according to claim 9 or 10, **characterized in that** the low value to which the speed (V) of the motor (58) is reduced, in step b),is less than zero, the direction of operation of the motor (58) being reversed.
